# EUROPÄISCHE PATENTSCHRIFT

(11) **EP 3 036 778 B1**
(45) Veröffentlichungstag und Bekanntmachung des Hinweises auf die Patenterteilung: **25.04.2018**
(21) Anmeldenummer: 15736430.8
(22) Anmeldetag: 06.07.2015
(51) Int. Cl.: H01L 41/047, H01L 41/083, H01L 41/293

(54) **BAUELEMENT ZUM ELEKTRISCHEN KONTAKTIEREN EINES PIEZOSTAPELS SOWIE PIEZOSTAPEL UND HERSTELLUNGSVERFAHREN MIT DEMSELBEN**
COMPONENT FOR ELECTRICALLY CONTACTING A PIEZO STACK, A PIEZO STACK, AND METHOD FOR PRODUCING SAME
COMPOSANT DESTINÉ À VENIR EN CONTACT ÉLECTRIQUE AVEC UN EMPILEMENT PIÉZO-ÉLECTRIQUE ET EMPILEMENT PIÉZO-ÉLECTRIQUE ET PROCÉDÉ DE FABRICATION DUDIT COMPOSANT

(30) Priorität: 18.07.2014 DE 102014214018
(43) Veröffentlichungstag der Anmeldung: 29.06.2016
(73) Patentinhaber: Continental Automotive GmbH, 30165 Hannover (DE)
(72) Erfinder: LAUTENSCHLÄGER, Alexandra, 93339 Riedenburg Flügelsberg (DE); UNRUH, Marcus, 93055 Regensburg (DE); ZUMSTRULL, Claus, 93128 Regenstauf (DE)
(86) Internationale Anmeldenummer: PCT/EP2015/065360
(87) Internationale Veröffentlichungsnummer: WO 2016/008756

(56) Entgegenhaltungen:
- WO-A2-2004/027887
- DE-C1- 19 945 933
- DE-U1-202014 100 666
- US-A1- 2009 127 982

## Beschreibung

Die Erfindung betrifft ein Piezobauelement, ein Kontaktierungsbauelement zum elektrischen Kontaktieren eines Piezostapels sowie ein Verfahren zum Herstellen eines solchen Piezobauelements.

Piezokeramische Stapel, auch bekannt als Piezostapel oder als Piezostack, die häufig in Antrieben von Kraftstoffinjektoren verwendet werden, bestehen gewöhnlich aus einer Vielzahl von piezoelektrischen Elementen, z. B. Keramikschichten, die übereinander gestapelt sind. Handelsübliche Piezostapel weisen häufig mehr als 300 solcher Keramikschichten auf. Zur Erzeugung einer Längenänderung des Piezostapels, dem sogenannten Hub, werden die Elemente einem elektrischen Feld ausgesetzt. Der piezoelektrische Effekt bewirkt dabei eine Dehnung der Piezokeramik. Die Summe der Dehnungen der Piezostack-Einzelschichten ergibt den Hub des gesamten Piezostapels. Das elektrische Feld wird mittels sog. Innenelektroden erzeugt, die ober- und unterhalb jeder einzelnen Keramikschicht angeordnet sind. Es befinden sich also zwischen den einzelnen Keramikschichten abwechselnd eine positive und eine negative Innenelektrode, welche mit elektrischer Ladung zyklisch geladen und wieder entladen werden. Die Kontaktierung der Innenelektroden erfolgt in der Regel über eine Außenmetallisierung auf Seitenflächen des Piezostapels. Die Außenmetallisierung kontaktiert dabei jeweils nur jede zweite Innenelektrode, jeweils um eine Elektrode versetzt zur gegenüberliegenden Außenmetallisierung.

Bei der zyklischen Dehnung des Piezostapels entstehen während der Lebensdauer des Gesamt-Piezobauelements Dehnungsrisse in der Keramik und in der Außenmetallisierung. Beispielsweise beträgt eine übliche Anzahl von Längenänderungszyklen in der Lebensdauer eines Piezoaktors mehr als 10⁹ Zyklen. Die entstandenen Risse können zu einer Unterbrechung der elektrischen Kontaktierung bzw. der durch die Risse abgehängten Innenelektroden führen und damit die Längenänderung des Piezostapels beeinträchtigen oder sogar verhindern.

Jede aktive Schicht, d. h. jede positive und negative Innenelektrode, die ein elektrisches Feld für die dazwischen befindliche Keramikschicht erzeugen soll, sollte daher nach Möglichkeit dauerhaft kontaktiert sein. Diese Voraussetzung sollte auch in den Randzonen an den oberen und unteren Stirnflächen des Piezostapels erfüllt sein. Da die Piezostapel-Stirnflächen in der Regel einen mechanischen Kontakt mit angrenzenden Bauteilen aus Metall haben, ist der verbleibende Abstand für eine elektrische Isolierung gegen die angrenzenden metallischen Bauteile oft sehr gering. Eine Anforderung an die Kontaktierung ist daher eine sehr hohe Positionsgenauigkeit während der Montage, damit so vorzugsweise gewährleistet wird, dass eine nachfolgend aufgebrachte Isolation sowohl die Kontaktierung der Innenelektroden als auch die Seitenflächen des Piezostapels prozesssicher und ausreichend isoliert. Normalerweise sind die Kontaktstellen zwischen den keramischen Innenelektroden bzw. der Außenmetallisierung und einer daran angebrachten Kontaktierung empfindlich gegenüber mechanischen Lasten, wie beispielsweise Zuglasten, Scherkräften oder Vibrationen. Im Allgemeinen wird daher gefordert, solche Lasten auf den Kontaktstellen an der Keramik-Oberfläche zu vermeiden. Allerdings ist die Vermeidung solcher Lasten häufig nicht möglich.

Die Fig. 17 und Fig. 18 zeigen ein Piezobauelement 10 nach dem Stand der Technik, wie es beispielsweise in US 2009/0127982 A1 beschrieben ist.

Das Piezobauelement 10 weist einen Piezostapel 12 auf, der an zwei sich gegenüberliegenden Seitenflächen 14 über eine Außenmetallisierung 16 elektrisch kontaktiert ist. Die Kontaktierung 18 erfolgt dabei über ein erstes mäanderförmiges Kontaktierungselement 20, das direkt an der Außenmetallisierung 16 aufgebracht ist, und ein im oberen Bereich des Piezostapels 12 direkt mit dem ersten Kontaktierungselement 20 in Kontakt stehendes zweites Kontaktierungselement 22, das sich über den Piezostapel 12 hinaus erstreckt, um so von außen kontaktiert werden zu können.

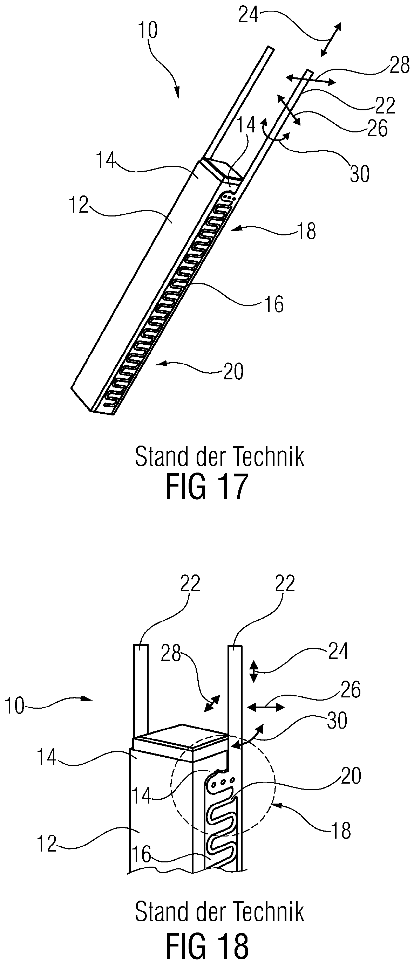

Wie in Fig. 18 zu sehen, können von außen auf das zweite Kontaktierungselement 22 Kräfte einwirken, nämlich beispielsweise axiale Kräfte 24, radiale Kräfte 26, laterale Kräfte 28 und Torsionskräfte 30. Solche Kräfte werden, da das zweite Kontaktierungselement 22 im eingekreisten Bereich direkt mit dem ersten Kontaktierungselement 20 verbunden ist, unmittelbar auf das erste Kontaktierungselement 20 übertragen. Dadurch kann es insbesondere im oberen Bereich des Piezostapels 12 zur Ablösung des Kontaktierungselementes 20 kommen. Die Kräfte können sich jedoch auch weiter nach unten in dem ersten Kontaktierungselement 20 fortsetzen und auch dort zu unerwünschten Ablösungen der Kontaktierung 18 führen. Weitere Möglichkeiten zur elektrischen Kontaktierung von Piezostapeln mit Mäander- und/oder Drahtharfen-Kontaktelementen sind aus DE 20 2014 100 666 U1, WO 2004/027887 A2 und DE 199 45 933 C1 bekannt.

Aufgabe der Erfindung ist es daher, eine Kontaktierung für einen Piezostapel vorzuschlagen, die weniger empfindlich gegenüber von außen einwirkenden Kräften ist.

Diese Aufgabe wird mit einem Piezobauelement mit den Merkmalen des Anspruches 1 gelöst.

Ein Kontaktierungsbauelement sowie ein Verfahren zur Herstellung eines solchen Piezobauelementes sind Gegenstand der nebengeordneten Ansprüche.

Vorteilhafte Ausgestaltungen der Erfindung sind Gegenstand der abhängigen Ansprüche.

Ein Piezobauelement weist einen Piezostapel mit einer Mehrzahl von in einer Längserstreckungsrichtung des Piezostapels übereinander gestapelten piezoelektrischen Elementen mit dazwischen angeordneten Elektrodenschichten zur Bildung von Innenelektroden sowie ein Kontaktierungsbauelement zum elektrischen Kontaktieren des Piezostapels auf. Das Kontaktierungsbauelement weist eine elektrisch leitfähige Mäanderstruktur zum elektrischen Inkontaktbringen des Kontaktierungsbauelements mit den Innenelektroden und eine elektrisch leitfähige Kontaktierungseinrichtung zum elektrischen Kontaktieren des Kontaktierungsbauelements von außerhalb des Piezostapels auf. Die Mäanderstruktur und die Kontaktierungseinrichtung sind beabstandet zueinander angeordnet. Es ist ein Verbindungselement zum elektrisch leitfähigen Verbinden der Kontaktierungseinrichtung und der Mäanderstruktur und zum Kräfteentkoppeln zwischen der Kontaktierungseinrichtung und der Mäanderstruktur vorgesehen.

Durch Verwendung des Kontaktierungsbauelementes kann eine Kontaktierung der Innenelektroden des Piezostapels zuverlässig mit einer langen Lebensdauer realisiert werden, denn Kräfte, die auf die Kontaktierungseinrichtung des Kontaktierungsbauelementes von außen einwirken, werden durch das besonders ausgebildete Verbindungselement nicht mehr an die Mäanderstruktur weitergegeben, so dass diese sich nicht durch von außen wirkende Kräfte von den Innenelektroden lösen kann.

Piezostapel weisen zumeist vorteilhaft einen inaktiven Bereich und einen aktiven Bereich auf, wobei der inaktive Bereich zur Isolierung des Piezostapels herangezogen wird. Um eine besonders gute Kontaktierung des aktiven Bereiches des Piezostapels zu erreichen, erstreckt sich die Mäanderstruktur vorzugsweise über den gesamten aktiven Bereich in der Längserstreckungsrichtung des Piezostapels.

Vorzugsweise ist die Mäanderstruktur in direktem Kontakt mit dem Piezostapel angeordnet, während die Kontaktierungseinrichtung und das Verbindungselement radial zu dem Piezostapel beabstandet angeordnet sind. Dadurch ist vorteilhaft gewährleistet, dass nur die Mäanderstruktur einen elektrischen Kontakt zu den Innenelektroden des Piezostapels herstellt. Da sowohl das Verbindungselement als auch die Kontaktierungseinrichtung von dem Piezostapel beabstandet sind, besteht vorzugsweise keine Gefahr, dass eine ungewollte, ungünstige Kontaktierung der Kontaktierungseinrichtung zu den Innenelektroden entsteht.

Vorzugsweise ist die Mäanderstruktur, insbesondere unter Verwendung von Leitkleber an eine Seitenfläche des Piezostapels geklebt. Dabei kann die Seitenfläche eine Außenmetallisierung aufweisen oder nicht. Alternativ ist es auch möglich, dass die Mäanderstruktur an eine zusätzlich aufgebrachte Außenmetallisierung an dem Piezostapel gelötet ist. So kann jeweils eine vorteilhafte sichere elektrische Kontaktierung von Mäanderstruktur zu Innenelektroden des Piezostapels realisiert werden.

Vorteilhaft weist der Piezostapel wenigstens vier Seitenflächen auf, die über Eckbereiche miteinander verbunden sind. Dabei ist die Mäanderstruktur vorzugsweise an einer ersten Seitenfläche angeordnet, wobei die Kontaktierungseinrichtung vorteilhaft an einer zweiten Seitenfläche angeordnet ist, die zu der ersten Seitenfläche bevorzugt benachbart ist. Das Verbindungselement erstreckt sich dabei um einen Endbereich, der die erste und die zweite Seitenfläche vorzugsweise miteinander verbindet. Dadurch ist die Kontaktierungseinrichtung im Wesentlichen um 90° versetzt zu der Mäanderstruktur angeordnet, und zwar vorzugsweise so, dass sich die Kontaktierungseinrichtung an der Seitenfläche des Piezostapels befindet, die keine Außenmetallisierung aufweist, sondern beispielsweise eine Isolationsfläche. Dadurch ergeben sich vorteilhaft ausreichende Kriechstromstrecken auf der Oberfläche der Isolationsfläche.

Der Piezostapel weist vorteilhaft einen ersten und einen zweiten Abschlussbereich auf, wobei sich die Kontaktierungseinrichtung über wenigstens einen der Abschlussbereiche hinaus erstreckt. Dadurch kann die Kontaktierungseinrichtung vorteilhaft gut von außen kontaktiert werden.

Besonders bevorzugt weist die Kontaktierungseinrichtung in dem Bereich, in dem sie sich über den Abschlussbereich hinaus erstreckt, eine Isolationshülse auf, um so besonders vorteilhaft die Kontaktierungseinrichtung von anderen Elementen des Piezobauelementes isolieren zu können.

Besonders bevorzugt ist es, wenn sich diese Isolationshülse bis in einen Abstand hinein erstreckt, der zwischen einem Abzweigungselement an der Kontaktierungseinrichtung und der Kontaktierungseinrichtung selbst gebildet ist. Es liegt dann vorteilhaft eine Isolationshülse vor, die einen möglichst großen Bereich des Kontaktierungsbauelementes abisoliert und nur einen oberen Bereich des Kontaktierungsbauelementes zur vorteilhaften Kontaktierung von außen frei lässt.

Um eine vorteilhaft besonders gute elektrische Kontaktierung der Innenelektroden des Piezostapels erreichen zu können, sind bevorzugt zwei Kontaktierungsbauelemente vorgesehen, deren Mäanderstrukturen jeweils an sich gegenüberliegenden Seitenflächen, insbesondere an mit Außenmetallisierung versehenen Seitenflächen, des Piezostapels angeordnet sind.

Weiter vorteilhaft ist es, wenn der Piezostapel ein vollaktiver Piezostapel ist, da so ein möglichst großer Hub bei Beaufschlagung mit einem elektrischen Feld erzielt werden kann.

Vorzugsweise sind der Piezostapel und das daran befestigte Kontaktierungsbauelement von einem Kunststoffkäfig zur Isolierung umgeben.

Zusätzlich weist das Piezobauelement zur Isolierung vorteilhaft einen Verguss, der insbesondere gebildet ist mit Silikon, um den Piezostapel mit dem Kontaktierungsbauelement und den optionalen Kunststoffkäfig auf.

Ein Kontaktierungsbauelement zum elektrischen Kontaktieren eines Piezostapels weist eine elektrisch leitfähige Mäanderstruktur zum elektrischen Inkontaktbringen des Kontaktierungsbauelements mit Innenelektroden des Piezostapels und eine elektrisch leitfähige Kontaktierungseinrichtung zum elektrischen Kontaktieren des Kontaktierungsbauelements von außerhalb des Piezostapels auf. Die Mäanderstruktur und die Kontaktierungseinrichtung sind beabstandet zueinander angeordnet. Weiter ist ein Verbindungselement zum elektrisch leitfähigen Verbinden der Kontaktierungseinrichtung und der Mäanderstruktur und zum Kräfteentkoppeln zwischen der Kontaktierungseinrichtung und der Mäanderstruktur vorgesehen.

Eine Mäanderstruktur, die zum Kontaktieren der Innenelektroden vorgesehen ist, kann sich mit dem Hub des Piezostapels bei Beaufschlagung mit einem elektrischen Feld ausdehnen und zusammenziehen, so dass dadurch die Ablösung einer Kontaktierung bereits vermieden werden kann. Um nun weiter zu vermeiden, dass von außen auf die Kontaktierungseinrichtung wirkende Kräfte zu einer Ablösung der Mäanderstruktur führen, wird nun die Mäanderstruktur von der Kontaktierungseinrichtung in Bezug auf einwirkende mechanische Kräfte entkoppelt. Dazu werden Mäanderstruktur und Kontaktierungseinrichtung beabstandet zueinander angeordnet. Damit können Kräfte, die auf die Kontaktierungseinrichtung wirken, nicht mehr auf die Mäanderstruktur übertragen werden.

Um eine elektrisch leitfähige Verbindung zwischen Kontaktierungseinrichtung und Mäanderstruktur bereitzustellen, wird ein Verbindungselement zwischen Mäanderstruktur und Kontaktierungseinrichtung angeordnet. Dieses Verbindungselement ist so ausgebildet, dass es Kräfte, die auf die Kontaktierungseinrichtung wirken, nicht zur Mäanderstruktur übertragen werden können, so dass die Kräfteentkopplung zwischen Mäanderstruktur und Kontaktierungseinrichtung trotz elektrischer Verbindung erhalten bleibt.

Entsprechend wird eine Kombination aus einer in Längserstreckungsrichtung des Piezostapels dehnungsfähigen Mäanderstruktur mit einem kräfteentkoppelnden Verbindungselement bereitgestellt.

Durch die einteilig zusammenhänge Mäanderstruktur, die an der Oberfläche des Piezostapels angebracht werden kann, kann auch das Vorsehen von freien Einzelverbindungen vermieden werden, wie es teilweise im Stand der Technik bekannt ist. Dadurch ist eine präzise Positionierung auf der Oberfläche des Piezostapels möglich. Die Mäandergeometrie ist zug- und biegeelastisch und passt sich daher der Längenänderung des Piezostapels, d. h. dem Piezohub, an.

Ein weiterer Vorteil liegt in der Beabstandung der Mäanderstruktur von der Kontaktierungseinrichtung. Durch diese geometrisch entfernte Anordnung ergeben sich hinsichtlich einer normalerweise an einem Piezobauelement vorhandenen elektrischen Isolation ausreichende Kriechstromstrecken auf der Oberfläche dieser Isolation und damit erheblich verbesserte konstruktive Möglichkeiten.

Der nach außen gehende Kontakt, d. h. die Kontaktierungseinrichtung, hat automatisch einen Abstand zum Piezostapel, ohne dass wie im Stand der Technik eine empfindliche Z-Biegung von der auf dem Piezostapel anhaftenden Kontaktierung erforderlich ist.

Vorzugsweise sind Mäanderstruktur, Verbindungselement und Kontaktierungseinrichtung nicht in einer Ebene angeordnet, sondern das Verbindungselement weist eine Biegung entlang seiner Längserstreckungsrichtung auf, so dass zwischen Mäanderstruktur und Kontaktierungseinrichtung ein im Wesentlichen senkrechter Winkel gebildet wird. So kann vorteilhaft die Mäanderstruktur an einer Seitenfläche des Piezostapels angebracht werden, an der beispielsweise eine Außenmetallisierung vorliegt, während die Kontaktierungseinrichtung sich an einer anderen Seitenfläche des Piezostapels befindet, wo beispielsweise keine Außenmetallisierung vorliegt. So kann vorteilhaft eine besonders gute Isolierung zur Vermeidung von Überschlägen realisiert werden.

Vorzugsweise erstreckt sich die Mäanderstruktur in einer Längserstreckungsrichtung des Piezostapels, wobei die Kontaktierungseinrichtung im Wesentlichen parallel zu der Längserstreckungsrichtung angeordnet ist. Durch die vorzugsweise parallele Anordnung von Mäanderstruktur und Kontaktierungseinrichtung ist es möglich, ein möglichst kleines Verbindungselement für eine vorzugsweise gute Kontaktierung zwischen den beiden Elementen bereitstellen zu können. So kann vorteilhaft Bauraum eingespart werden.

Das Verbindungselement weist eine Vielzahl von Drahtelementen auf, die auf einer ersten Drahtelementseite mit der Mäanderstruktur und auf einer zweiten Drahtelementseite, die der ersten Drahtelementseite gegenüberliegt, mit der Kontaktierungseinrichtung verbunden sind. Drahtelemente bilden eine besonders filigrane Verbindungsmöglichkeit zwischen der Mäanderstruktur und der Kontaktierungseinrichtung, die besonders auch in einem engen Bauraum untergebracht werden kann.

Vorzugsweise weist die Mäanderstruktur eine Mehrzahl an Mäanderschlingen auf, wobei an jeder zu der Kontaktierungseinrichtung gerichteten Mäanderschlinge vorteilhaft wenigstens zwei Drahtelemente angeordnet sind. Dadurch kann eine vorzugsweise besonders gute Kontaktierung zwischen Mäanderstruktur und Kontaktierungseinrichtung erreicht werden. Um eine besonders gute vorteilhafte Kontaktierung zwischen Mäanderstruktur und Kontaktierungseinrichtung realisieren zu können, sind beispielsweise etwa 70 - 130, insbesondere 90 - 110, Drahtelemente zwischen Mäanderstruktur und Kontaktierungseinrichtung jeweils als Ganze angeordnet.

Die Drahtelemente erstrecken sich im Wesentlichen parallel zueinander. Weiter erstrecken sich die Drahtelemente im Wesentlichen senkrecht zu der Längserstreckungsrichtung der Mäanderstruktur. Das bedeutet, die Drahtelemente sind im Wesentlichen senkrecht zu der Mäanderstruktur und der Kontaktierungseinrichtung angeordnet, so dass das Verbindungselement besonders wenig Platz zwischen Mäanderstruktur und Kontaktierungseinrichtung beansprucht.

Vorteilhaft sind die Drahtelemente zum Entkoppeln von axialen und/oder radialen und/oder lateralen und/oder Torsionskräften zwischen der Kontaktierungseinrichtung und der Mäanderstruktur ausgebildet. Dazu ist es besonders vorteilhaft, wenn die Drahtelemente insbesondere so zwischen Mäanderstruktur und Kontaktierungseinrichtung angeordnet sind, dass sie wenigstens in einer Raumrichtung, vorzugsweise in zwei Raumrichtungen, insbesondere in drei Raumrichtungen, flexibel sind. Besonders vorteilhaft ist dabei, wenn die Drahtelemente in ihrer Längserstreckungsrichtung flexibel sind. Durch eine solche Ausbildung werden externe Kräfte, die in axialer, radialer, lateraler oder Torsionsrichtung auf die Kontaktierungseinrichtung einwirken, besonders vorteilhaft nicht mehr auf die Mäanderstruktur übertragen, sondern vorzugsweise durch die Drahtelemente abgefedert.

Zu diesem Zweck ist es auch besonders vorteilhaft, wenn die Drahtelemente biegeweich sind. Dazu können sie beispielsweise aus einer Kupferlegierung wie CuSn₆ ausgebildet sein.

Vorteilhaft weist die Mäanderstruktur in der Längserstreckungsrichtung einen ersten Endbereich und einen zweiten Endbereich auf, wobei die Kontaktierungseinrichtung wenigstens über einen der Endbereiche der Mäanderstruktur hervorsteht. Dadurch ist es vorteilhaft möglich, von außen leicht an die Kontaktierungseinrichtung heran zu gelangen, um dann eine bevorzugte Kontaktierung von außen anlegen zu können.

Um vorteilhaft weiteren Bauraum einsparen zu können, ist die Kontaktierungseinrichtung vorzugsweise als Flachkontaktelement ausgebildet.

Vorzugsweise sind die Mäanderstruktur und das Verbindungselement einstückig ausgebildet. In weiterer vorteilhafter Ausgestaltung sind sowohl die Mäanderstruktur als auch die Kontaktierungseinrichtung als auch das Verbindungselement gemeinsam ausgebildet. Dadurch wird die Herstellung des Kontaktierungsbauelementes vorzugsweise vereinfacht, da das Kontaktierungsbauelement mit den Einzelelementen Mäanderstruktur, Verbindungselement und/oder Kontaktierungseinrichtung vorteilhaft in einem Verfahrensschritt hergestellt werden kann, beispielsweise durch Ausstanzen oder Ätzen aus einer Grundstruktur.

Vorteilhaft ist es, wenn die Mäanderstruktur, das Verbindungselement und die Kontaktierungseinrichtung eine gleiche Dicke aufweisen, denn so kann bevorzugt Bauraum optimal ausgenutzt werden. Dazu ist beispielsweise die Kontaktierungseinrichtung besonders vorteilhaft als Flachkontaktelement ausgebildet. "Gleiche Dicke" bedeutet, dass die drei Einzelelemente sich senkrecht zu der Längserstreckungsrichtung der Mäanderstruktur und auch senkrecht einer Erstreckungsrichtung der Drahtelemente - der Drahterstreckungsrichtung - zwischen der Kontaktierungseinrichtung und der Mäanderstruktur in eine Dickenrichtung erstrecken und dabei vorzugsweise die gleiche Erstreckungslänge aufweisen. Im Falle des Flachkontaktelements ist dann vorzugsweise seine Dicke in Dickenrichtung geringer als seine Breite in Drahterstreckungsrichtung.

Besonders vorteilhaft ist es, wenn die Dicke aller Elemente des Kontaktierungsbauelementes in einem Bereich zwischen 0,05 mm und 0,15 mm liegt. Dadurch nimmt das Kontaktierungsbauelement als Ganzes vorteilhaft nur wenig Bauraum in einem Piezobauelement ein.

Vorzugsweise ist an der Kontaktierungseinrichtung in einem Abstandsbereich, der parallel zu dem Endbereich der Mäanderstruktur angeordnet ist, über den die Kontaktierungseinrichtung hervorsteht, ein Abzweigungselement angeordnet. Das Abzweigungselement erstreckt sich vorzugsweise parallel zu der Längserstreckungsrichtung der Mäanderstruktur und der Kontaktierungseinrichtung und ist unter Ausbildung eines Abstandes vorteilhaft beabstandet zu der Kontaktierungseinrichtung angeordnet. Dabei sind die Drahtelemente in diesem Abstandsbereich statt an der Kontaktierungseinrichtung vorzugsweise an dem Abzweigungselement befestigt. Insgesamt ergibt sich daher vorzugsweise auch ein Abstand zwischen der Kontaktierungseinrichtung und den Drahtelementen bzw. der Mäanderstruktur. Dies ist besonders vorteilhaft, wenn die Kontaktierungseinrichtung in der Herstellung isoliert werden soll, da so eine Isolierung, beispielsweise in Form einer Isolierungshülse, in die die Kontaktierungseinrichtung vorzugsweise eingeschoben werden soll, vorzugsweise weit in den Bereich hineingezogen werden kann, in dem die Mäanderstruktur die Innenelektroden eines Piezostapels kontaktiert.

Das Abzweigungselement weist vorzugsweise eine im Wesentlichen senkrecht an der Kontaktierungseinrichtung befestigten Steg zum Bilden des Abstandes auf. Um eine besonders gute Isolierung erreichen zu können, ist dieser Abzweigungssteg bevorzugt so angeordnet, dass das Abzweigungselement sich über etwa 1/5 der Länge der Mäanderstruktur erstrecken kann.

In einem Verfahren zum Herstellen eines Piezobauelementes wird zunächst ein Piezostapel bereitgestellt, der eine Mehrzahl von in einer Längserstreckungsrichtung des Piezostapels übereinander gestapelte piezoelektrische Elemente aufweist, zwischen denen Elektrodenschichten als Innenelektroden angeordnet sind. Der Piezostapel, der bereitgestellt wird, weist wenigstens vier Seitenflächen auf, die über Eckbereiche miteinander verbunden sind. Zusätzlich wird in dem Verfahren ein Kontaktierungsbauelement wie oben beschrieben gebildet, das eine Mäanderstruktur, eine Kontaktierungseinrichtung und ein die Mäanderstruktur und die Kontaktierungseinrichtung elektrisch verbindendes Verbindungselement aufweist. Nachdem der Piezostapel bereitgestellt und das Kontaktierungsbauelement gebildet ist, wird die Mäanderstruktur des Kontaktierungsbauelementes an einer ersten Seitenfläche des Piezostapels derart elektrisch leitfähig befestigt, dass die Kontaktierungseinrichtung und das Verbindungselement beabstandet zu dem Piezostapel verbleiben. Danach werden die Kontaktierungseinrichtung und das Verbindungselement so umgebogen, dass sie auf eine zweite Seitenfläche des Piezostapels gelangen, die zu der ersten Seitenfläche benachbart ist, und um einen Eckbereich umgebogen sind, der die erste und die zweite Seitenfläche verbindet. Das Umbiegen erfolgt so, dass die Kontaktierungseinrichtung und das Verbindungselement auch von der zweiten Seitenfläche und von dem Eckbereich beabstandet verbleiben.

Es wird so eine flexible Kontaktierung der Innenelektroden des Piezostapels erreicht, bei dem nur die Mäanderstruktur der Kontaktierungseinrichtung fest mit dem Piezostapel verbunden ist. Um eine gute Isolierung zu erreichen, ist die Kontaktierungseinrichtung nicht nur in einer Raumrichtung beabstandet zu der Mäanderstruktur angeordnet, sondern auch um eine Ecke herum gebogen und tritt nicht in Kontakt mit den Elektroden des Piezostapels. Durch das besonders ausgebildete Verbindungselement werden Kräfte, die auf die Kontaktierungseinrichtung von außen einwirken, abgefangen und nicht zur Mäanderstruktur weitergeleitet.

Zum Bilden des Kontaktierungsbauelementes kann beispielsweise Blech verwendet werden, aus dem das Kontaktierungsbauelement mit sämtlichen Elementen, nämlich Mäanderstruktur, Verbindungselement und Kontaktierungseinrichtung ausgestanzt oder herausgeätzt wird. Alternativ ist es auch möglich, nur Mäanderstruktur und Verbindungselement aus einem Blech zu bilden und die Kontaktierungseinrichtung nachträglich daran anzubringen.

Die Befestigung der Mäanderstruktur kann beispielsweise durch Kleben mit Hilfe eines Leitklebers direkt an den Piezostapel oder durch Löten an beispielsweise eine Außenmetallisierung an dem Piezostapel erreicht werden.

Beim Umbiegen der Kontaktierungseinrichtung kann es vorteilhaft sein, wenn das Verbindungselement an mehreren Stellen gekröpft wird, d. h. wenn ein zunächst in einer Ebene ausgebildetes Kontaktierungsbauelement mehrere Knicke aufweist.

Beispielsweise kann der Bereich des Verbindungselementes an der Mäanderstruktur gekröpft werden, um so das Verbindungselement von dem Piezostapel zu beabstanden, wenn die Mäanderstruktur an den Piezostapel befestigt ist. Weiter kann beispielsweise auch eine Kröpfung im Bereich der Kontaktierungseinrichtung an dem Verbindungselement sinnvoll sein, um so ein Biegen um einen Eckbereich des Piezostapels zu erleichtern.

Vorteilhaft wird an der Kontaktierungseinrichtung eine Isolationshülse vorgesehen, um die Kontaktierungseinrichtung vorzugsweise weitgehend von elektrisch leitfähigen Bauelementen des Piezobauelementes isolieren zu können. Diese Isolationshülse kann beispielsweise schon an der Kontaktierungseinrichtung angebracht sein, bevor diese mit dem Verbindungselement verbunden wird - im Falle, dass sie nicht einstückig mit Mäanderstruktur und Verbindungselement gebildet wird -, bzw. bevor die Mäanderstruktur an den Piezostapel angebracht wird. Alternativ kann die Isolationshülle aber auch an die Kontaktierungseinrichtung angebracht werden, wenn das Kontaktierungsbauelement bereits an dem Piezostapel befestigt ist.

Optional kann ein Kunststoffkäfig zur weiteren Isolation um den Piezostapel mit dem Kontaktierungsbauelement, das daran befestigt worden ist, angeordnet werden.

Danach ist es vorteilhaft, wenn der Aufbau beispielsweise mit Silikon vergossen wird. Besonders vorteilhaft wird der Verguss so ausgebildet, dass sich auch die Isolationshülse in den Verguss hinein erstreckt.

Zum Schluss kann außen um den Verguss herum eine Rohrfeder angeordnet werden.

Vorteilhafte Ausgestaltungen der Erfindung werden nachfolgend anhand der beigefügten Zeichnungen näher erläutert. Darin zeigt:
- Fig. 1: eine erste Ausführungsform eines Kontaktierungsbauelementes, mit dem ein Piezostapel elektrisch kontaktiert werden kann;
- Fig. 2: eine zweite Ausführungsform eines solchen Kontaktierungsbauelementes;
- Fig. 3: ein Ablaufdiagramm von Verfahrensschritten zur Herstellung eines Piezobauelementes, das das Kontaktierungsbauelement aus Fig. 1 bzw. Fig. 2 aufweist;
- Fig. 4: einen Querschnitt durch das Kontaktierungsbauteil aus Fig. 1;
- Fig. 5: das Kontaktierungsbauelement aus Fig. 4 mit Kröpfung;
- Fig. 6: einen Piezostapel zur Verwendung in dem Verfahren nach Fig. 3 im Längsschnitt;
- Fig. 7: einen Piezostapel zur Verwendung in dem Verfahren nach Fig. 3;
- Fig. 8: das Anbringen des gekröpften Kontaktierungsbauelementes aus Fig. 5 an den Piezostapel aus Fig. 6 bzw. Fig. 7;
- Fig. 9: das Anbringen zweier Kontaktierungsbauelemente an einen Piezostapel mit einer Außenmetallisierung;
- Fig. 10: das Umbiegen des Kontaktierungsbauelementes um einen Eckbereich des Piezostapels;
- Fig. 11: der Piezostapel aus Fig. 7 mit daran angebrachtem Kontaktierungsbauelement, wobei eine Kontaktierungseinrichtung des Kontaktierungsbauelement als rundes Kontaktelement ausgebildet ist;
- Fig. 12: einen Piezostapel mit daran angebrachtem Konaktierungsbauelement, wobei die Kontaktierungseinrichtung als Flachkontakt ausgebildet ist;
- Fig. 13: den Aufbau aus Fig. 12 mit einem daran angeordneten Kunststoffkäfig und einem Verguss;
- Fig. 14: eine Draufsicht auf den Piezostapel aus Fig. 12 mit den Kontaktierungsbauelementen;
- Fig. 15: eine Draufsicht den Aufbau aus Fig. 13 mit Piezostapel, Kontaktierungsbauelement, Verguss, Rohrfeder; und
- Fig. 16: ein Piezobauelement mit von außen darauf einwirkenden Kräften;

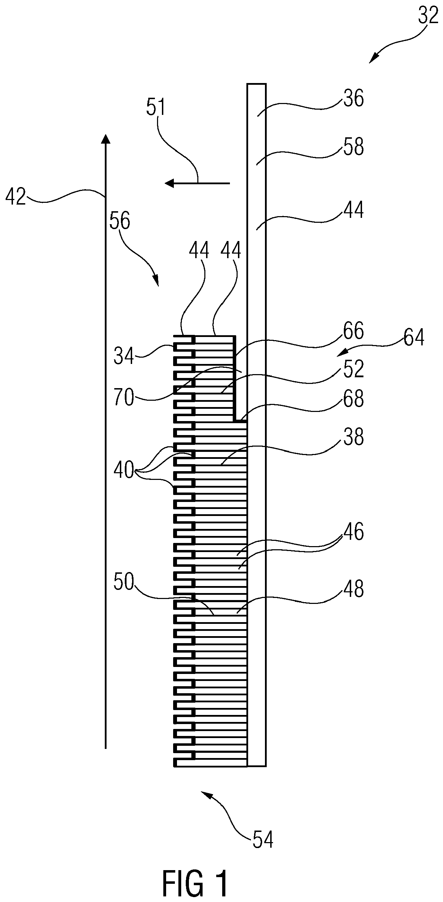

Figur 1 zeigt ein Kontaktierungsbauelement 32, mit dem ein Piezostapel 12 elektrisch kontaktiert werden kann.

Das Kontaktierungsbauelement 32 weist eine Mäanderstruktur 34, eine Kontaktierungseinrichtung 36 sowie ein Verbindungselement 38 auf. Die Mäanderstruktur 34 weist eine Vielzahl von Mäanderschlingen 40 auf und erstreckt sich in einer Längserstreckungsrichtung 42. Die Mäanderstruktur 34 soll später an einer Außenmetallisierung 16 eines Piezostapels 12 befestigt werden. Durch ihre mäandrisierende Form in Richtung der Längserstreckungsrichtung 42 ist die Mäanderstruktur 34 fähig, sich mit einem Hub des Piezostapels 12 auszudehnen und zusammen zu ziehen. Die Mäanderstruktur 34 ist aus einem leitfähigen Material 44 gebildet.

Die Kontaktierungseinrichtung 32 erstreckt sich parallel zu der Mäanderstruktur 34, ist jedoch beabstandet zu dieser angeordnet. Zur Verbindung von Kontaktierungseinrichtungen 36 und Mäanderstruktur 34 ist das Verbindungselement 38 zwischen Mäanderstruktur 34 und Kontaktierungseinrichtung 36 angeordnet und mit beiden Elementen in Kontakt. Auch das Verbindungselement 38 ist aus dem elektrisch leitfähigen Material 44 gebildet, um so eine elektrische Verbindung zwischen der Mäanderstruktur 34 und der Kontaktierungseinrichtung 36 herstellen zu können.

Das Verbindungselement 38 weist eine Vielzahl an Drahtelementen 46 auf, die auf einer ersten Drahtelementseite 50 mit der Mäanderstruktur 34 verbunden sind und auf einer zweiten Drahtelementseite 48 mit der Kontaktierungseinrichtung 36. Die Drahtelemente 46 erstrecken sich im Wesentlichen senkrecht zu der Längserstreckungsrichtung 42 in einer Drahterstreckungsrichtung 51.

Die Drahtelemente 46 sind biegeweich und somit in allen drei Raumrichtungen flexibel. Beispielsweise sind die Drahtelemente 46 aus einer Kupferlegierung 52 wie beispielsweise CuSn₆ gebildet.

Die Drahtelemente 46 können so axiale Kräfte 24, radiale Kräfte 26, laterale Kräfte 28 und Torsionskräfte 30, die auf die Kontaktierungseinrichtung 36 von außen einwirken können, aufnehmen und so von der Mäanderstruktur 34 entkoppeln.

Die Mäanderstruktur 34 weist in der Längserstreckungsrichtung 42 einen ersten Endbereich 54 und einen zweiten Endbereich 56 auf. In der vorliegenden Ausführungsform steht die Kontaktierungseinrichtung 36 über den zweiten Endbereich 56 hinaus, um so von außen gut kontaktiert werden zu können. Auch die Kontaktierungseinrichtung 36 ist aus dem leitfähigen Material 44 gebildet. Um Bauraum zu sparen, ist in der vorliegenden Ausführungsform die Kontaktierungseinrichtung 36 als Flachkontaktelement 58 ausgebildet. In eine Dickenrichtung 59 weisen die Mäanderstruktur 34, das Verbindungselement 38 und die Kontaktierungseinrichtung 36 somit etwa die gleiche Dicke 59' auf.

Das Kontaktierungsbauelement 32 bzw. seine Elemente Mäanderstruktur 34, Kontaktierungseinrichtung 36 und Verbindungselement 38 sind in der vorliegenden Ausführungsform einstückig ausgebildet, beispielsweise durch Ausstanzen bzw. Ausätzen aus einem Legierungsblech.

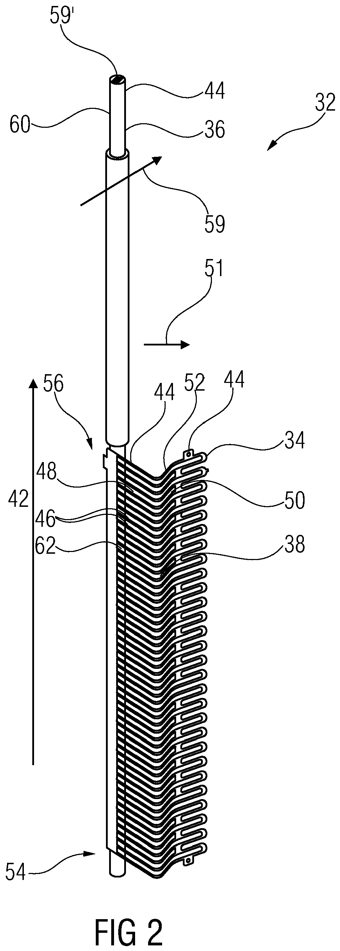

In Fig. 2 ist eine zweite Ausführungsform eines Kontaktierungsbauelementes 32 gezeigt. Hier ist die Mäanderstruktur 34 mit dem Verbindungselement 38 einstückig gebildet, jedoch die Kontaktierungseinrichtung 36 als ein separates Element ausgebildet, das beispielsweise durch Löten oder Schweißen an das Verbindungselement 38 angebracht ist. Dazu weist das Verbindungselement 38 neben den Drahtelementen 46 einen Befestigungssteg 62 auf, an dem die Kontaktierungseinrichtung 36 befestigt werden kann. Hier ist die Kontaktierungseinrichtung 36 nicht als Flachkontaktelement 58, sondern als rundes Kontaktelement 60 ausgebildet.

Das Kontaktierungsbauelement 32 der ersten Ausführungsform gezeigt in Fig. 1, unterscheidet sich von der zweiten Ausführungsform des Kontaktierungsbauelementes gemäß Fig. 2 noch zusätzlich durch eine Beabstandung der Kontaktierungseinrichtung 36 im oberen Bereich der Mäanderstruktur 34 von den Drahtelementen 46. Dazu weist die Kontaktierungseinrichtung 36 in einem oberen Abstandsbereich 64, der parallel zu dem Endbereich 56 angeordnet ist, über den die Kontaktierungseinrichtung 36 hervorsteht, ein Abzweigungselement 66 auf. Das Abzweigungselement 66 erstreckt sich parallel zu der Mäanderstruktur 34 und der Kontaktierungseinrichtung 36 und weist einen Steg 68 auf, der am unteren Ende des Abzweigungselementes 66 angeordnet ist und sich senkrecht zu der Kontaktierungseinrichtung 36 erstreckt. Dadurch entsteht ein Abstand 70 zu der Kontaktierungseinrichtung 36. Die Drahtelemente 46 sind in diesem Abstandsbereich 64 nicht an der Kontaktierungseinrichtung 36 befestigt, sondern an dem Abzweigungselement 66. Dadurch kann in den Abstand 70 ein Isolierungselement eingefügt werden.

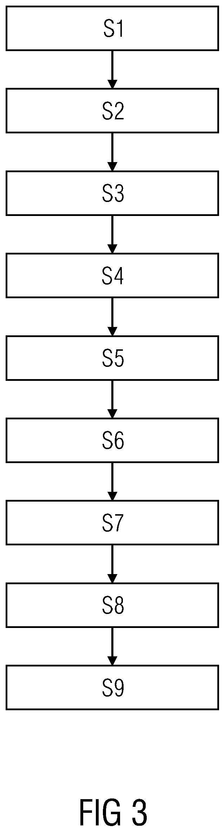

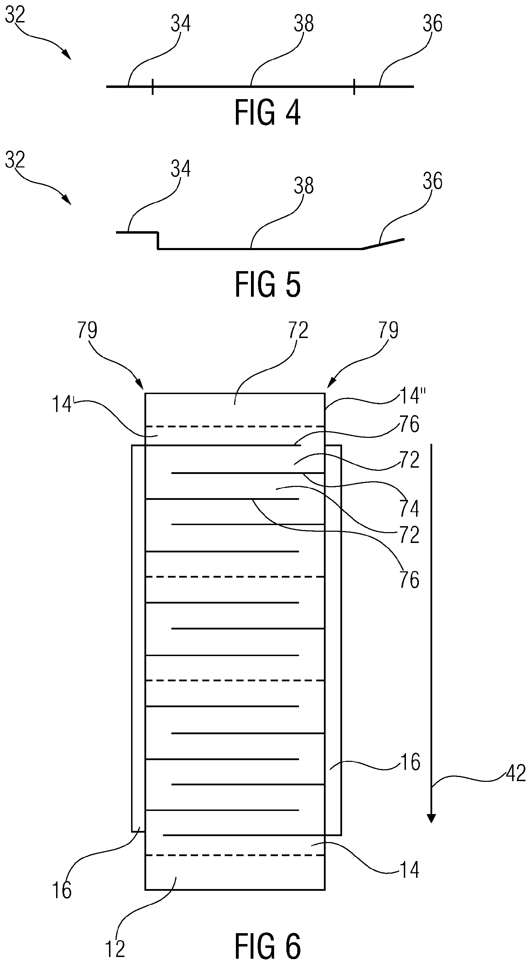

Fig. 3 zeigt ein Ablaufdiagramm, dass die Herstellung eines Piezobauelements 10 darstellt. Die Figuren 4 - 13 dienen dabei zur Veranschaulichung des Verfahrens.

Zunächst wird in Schritt S1 das Kontaktierungsbauelement 32 hergestellt. Ein Querschnitt durch das Kontaktierungsbauelement 32 mit Mäanderstruktur 34, Kontaktierungseinrichtung 36 und Verbindungselement 38 ist hierzu in Fig. 4 dargestellt.

Um das Kontaktierungsbauelement 32 ohne größere sterische Hinderung später befestigen zu können, wird es in einem Schritt S2 zunächst im Bereich der Mäanderstruktur 34 und im Bereich der Kontaktierungseinrichtung 36 an dem Verbindungselement 38 gekröpft, wie in Fig. 5 gezeigt.

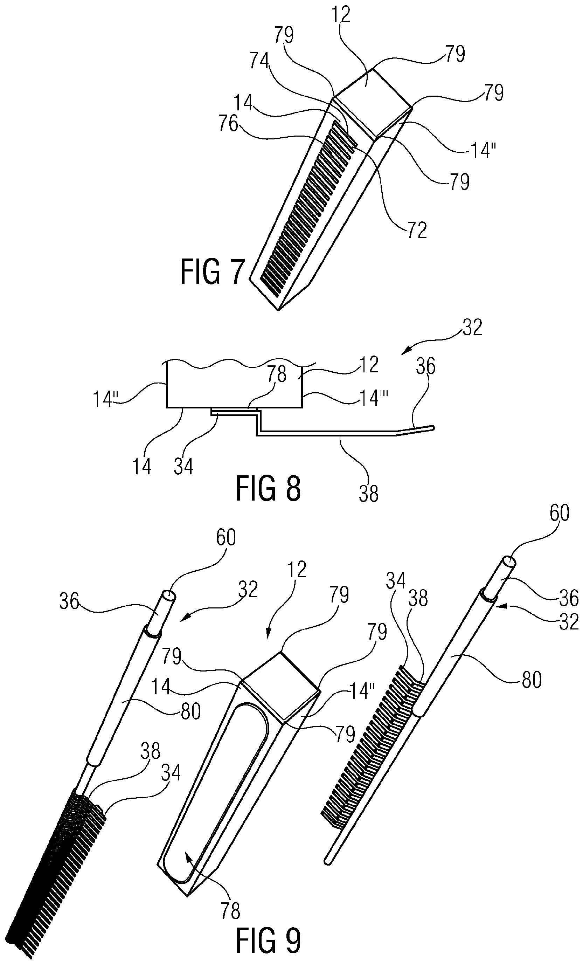

In einem Schritt S3 wird ein in den Fig. 6 und Fig. 7 gezeigter Piezostapel 12 bereitgestellt.

Der Piezostapel 12 weist eine Mehrzahl von in der Längserstreckungsrichtung 42 übereinander gestapelten piezoelektrischen Elementen 72 auf, zwischen denen Elektrodenschichten 74 als Innenelektroden 76 angeordnet sind.

Der Piezostapel 12 weist in der vorliegenden Ausführungsform vier Seitenflächen 14, 14', 14", 14''' auf, von denen drei Seitenflächen 14, 14', 14" zu sehen sind. An sich gegenüberliegenden Seitenflächen 14, 14' ist jeweils eine Außenmetallisierung 16 vorgesehen. Die Seitenfläche 14" weist keine Außenmetallisierung 16 auf.

In einem Schritt S4 des Verfahrens, gezeigt in Fig. 8, wird das gekröpfte Kontaktierungsbauelement 32 aus Fig. 5 mit der Mäanderstruktur 34 an einer der Seitenflächen 14', 14" des Piezostapels befestigt, so dass die Mäanderstruktur 34 in Kontakt mit der Außenmetallisierung 16 ist.

In Fig. 9 ist gezeigt, dass auf zwei sich gegenüberliegenden Seitenflächen 14', 14" des Piezostapels 12 jeweils ein Kontaktierungsbauelement 32 mit der jeweiligen Mäanderstruktur 34 befestigt wird, und zwar über Ankleben mittels einer Schicht eines Leitklebers 78. In Schritt S4 kann die Mäanderstruktur 34 statt Kleben auch über eine Lötschicht an der Außenmetallisierung 16 befestigt werden.

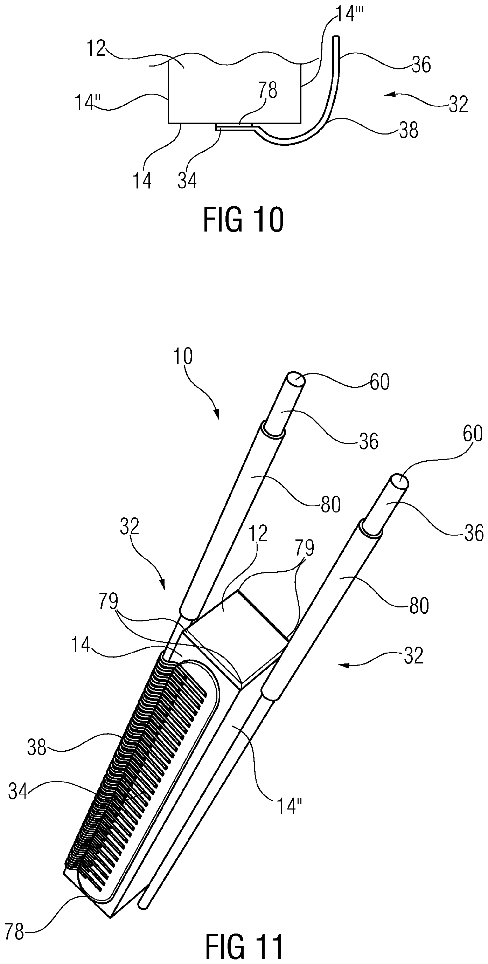

In Schritt S5 wird das Verbindungselement 38 des an dem Piezostapel 12 befestigten Kontaktierungsbauelementes 32 um einen Eckbereich 79 des Piezostapels 12 umgebogen, so dass die Kontaktierungseinrichtung 36 auf die Seitenfläche 14" gelangt, wo keine Außenmetallisierung 16 angeordnet ist. Dies ist in Fig. 10 dargestellt.

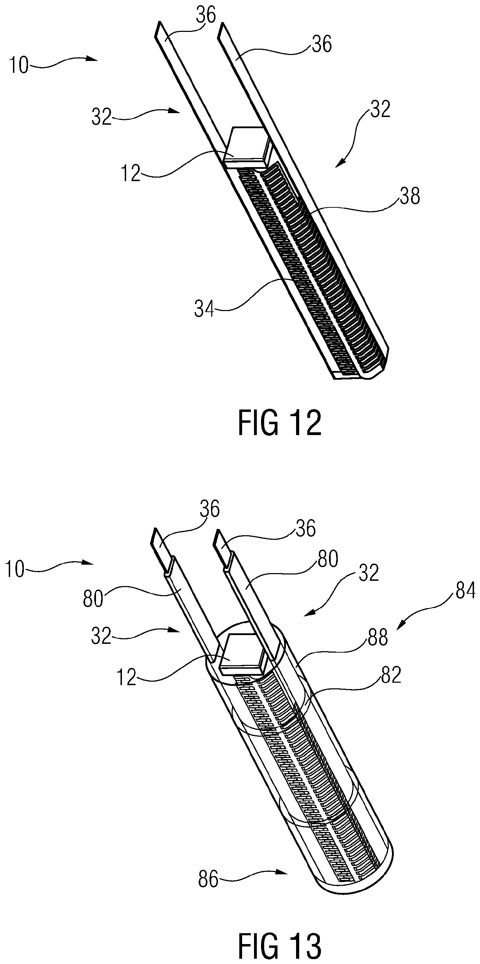

Fig. 11 zeigt eine perspektivische Ansicht auf den Piezostapel 12 mit daran angebrachten und umgebogenen Kontaktierungsbauelementen 32. Dabei wurde in Fig. 11 die zweite Ausführungsform des Kontaktierungsbauelementes 32, die in Fig. 2 gezeigt ist, verwendet. Alternativ kann jedoch auch, wie in Fig. 12 gezeigt, die erste Ausführungsform des Kontaktierungsbauelementes 32 zur Befestigung an dem Piezostapel 12 verwendet werden. Wie in Fig. 11 und Fig. 12 zu sehen ist, ist nur das die Mäanderstruktur 34 mit dem Piezostapel 12 in direktem Kontakt, während das Verbindungselement 38 und die Kontaktierungseinrichtung 36 beabstandet zu dem Piezostapel angeordnet sind.

In einem Schritt S6 wird, wie in Fig. 13 gezeigt, die Kontaktierungseinrichtung 36 mit einer Isolationshülse 80 versehen.

Dieser Schritt S6 ist optional, da die Isolationshülse 80, wie beispielsweise in Fig. 9 gezeigt, bereits vor Anbringen des Kontaktierungsbauelementes 32 an den Piezostapel 12 an der Kontaktierungseinrichtung 36 angeordnet sein kann.

In einem ebenfalls optionalen Schritt S7 kann dann ein Kunststoffkäfig 82 um den Aufbau aus Piezostapel 12 und Kontaktierungsbauelementen 32 angeordnet werden.

Wie ebenfalls in Fig. 12 und Fig. 13 zu sehen ist, weist der Piezostapel 12 einen ersten Abschlussbereich 84 und einen zweiten Abschlussbereich 86 auf, wobei sich die an dem Piezostapel 12 befestigten Kontaktierungseinrichtungen 36 über den ersten Abschlussbereich 84 hinaus erstrecken. In diesem Bereich ist auch die Isolationshülse 80 angeordnet.

In einem Schritt S8 wird der Gesamtaufbau dann mit einem Vergussmaterial 88, beispielsweise Silikon, vergossen.

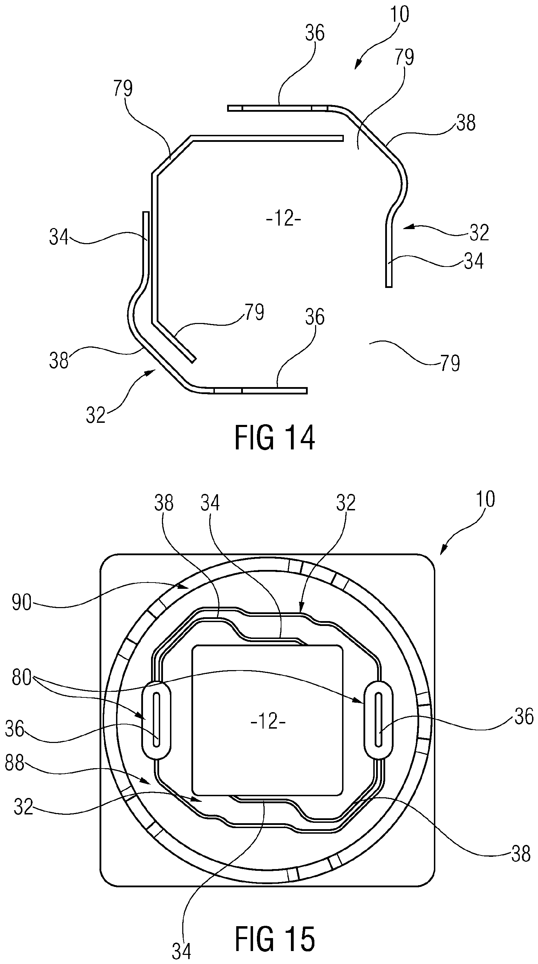

Zum Schluss wird in einem Schritt S9 eine Rohrfeder 90 um den Gesamtaufbau angebracht, wie dies beispielsweise in Fig. 15 gezeigt ist.

In Fig. 14 ist im Querschnitt durch das Piezobauelement 10 dargestellt, der gezeigt, wie zwei Kontaktierungsbauelemente 32 an einem Piezostapel 12 angebracht sind und zwar derart, dass nur die Mäanderstruktur 34 in Kontakt mit dem Piezostapel 12 ist, während die Verbindungselemente 38 und die Kontaktierungseinrichtungen 36 jeweils von den Eckbereichen 79 und den jeweiligen Seitenflächen 14" beabstandet angeordnet sind.

Fig. 15 zeigt einen Querschnitt durch den gesamten Aufbau des Piezobauelementes 10, wobei im Inneren der Piezostapel 12 angeordnet ist und daran die Kontaktierungsbauelemente 32 angebracht sind. Die Kontaktierungseinrichtungen 36 der Kontaktierungsbauelemente 32 weisen dabei Isolationshülsen 80 auf. Das Piezobauelement 10 ist mit einem Vergussmaterial 88 vergossen, wobei um das Vergussmaterial 88 zusätzlich eine Rohrfeder 90 angeordnet ist, um das Piezobauelement 10 mit einer Vorspannung zu beaufschlagen.

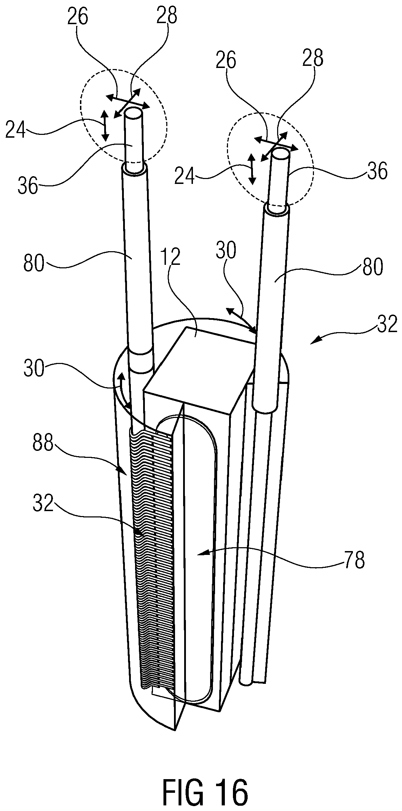

In Fig. 16 ist gezeigt, wie Kräfte von außen auf die Kontaktierungseinrichtungen 36 des Piezobauelementes 10 einwirken. Diese Kräfte werden jedoch durch den besonderen Aufbau der Kontaktierungsbauelemente 32 nicht mehr auf die Mäanderstrukturen 34 übertragen, so dass ein Ablösen der Mäanderstruktur 34 von dem Piezostapel 12 vermieden werden kann.

Es wird demgemäß ein dauerhaft elastisches dehnbares bzw. biegbares Kontaktierungsbauelement 32 zur Verfügung gestellt, das die Bildung von Rissen in der Kontaktierung eines Piezostapels 12 vermeidet. Daher müssen potentielle Risse nicht mehr, wie dies bisher geschah, überbrückt oder umgangen werden. Insgesamt wird vermieden, dass Kräfte aus der Umgebung, die auf die Kontaktierungseinrichtung 36 einwirken, beispielsweise Montagekräfte, Vibrationskräfte im Betrieb, Kräfte durch thermische Dehnungen von angrenzenden Bauteilen usw., zur Beschädigung der Kontaktierung an der Piezostapeloberfläche führen.

### Bezugszeichenliste

- 10: Piezobauelement
- 12: Piezostapel
- 14: Seitenfläche
- 14': Seitenfläche
- 14": Seitenfläche
- 14'": Seitenfläche
- 16: Außenmetallisierung
- 18: Kontaktierung
- 20: erstes Kontaktierungselement
- 22: zweites Kontaktierungselement
- 24: axiale Kraft
- 26: radiale Kraft
- 28: laterale Kraft
- 30: Torsionskraft
- 32: Kontaktierungsbauelement
- 34: Mäanderstruktur
- 36: Kontaktierungseinrichtung
- 38: Verbindungselement
- 40: Mäanderschlinge
- 42: Längserstreckungsrichtung
- 44: leitfähiges Material
- 46: Drahtelement
- 48: zweite Drahtelementseite
- 50: erste Drahtelementseite
- 51: Drahterstreckungsrichtung
- 52: Kupferlegierung
- 54: erster Endbereich
- 56: zweiter Endbereich
- 58: Flachkontaktelement
- 59: Dickenrichtung
- 59': Dicke
- 60: rundes Kontaktelement
- 62: Befestigungssteg
- 64: Abstandsbereich
- 66: Abzweigungselement
- 68: Steg
- 70: Abstand
- 72: piezoelektrisches Element
- 74: Elektrodenschicht
- 76: Innenelektrode
- 78: Leitkleber
- 79: Eckbereich
- 80: Isolationshülse
- 82: Kunststoffkäfig
- 84: erster Abschlussbereich
- 86: zweiter Abschlussbereich
- 88: Vergussmaterial
- 90: Rohrfeder
- S1: Bilden eines Kontaktierungsbauelements
- S2: Kröpfen des Kontaktierungsbauelementes
- S3: Bereitstellen eines Piezostapels
- S4: Befestigen des Kontaktierungsbauelementes an dem Piezostapel
- S5: Umbiegen des Kontaktierungsbauelementes
- S6: Anbringen einer Isolationshülse
- S7: Anordnen eines Kunststoffkäfigs
- S8: Verguss
- S9: Anbringen einer Rohrfeder

## Patentansprüche

1. Kontaktierungsbauelement (32) zum elektrischen Kontaktieren eines Piezostapels (12),
aufweisend eine elektrisch leitfähige Mäanderstruktur (34) zum elektrischen Inkontaktbringen des Kontaktierungsbauelements (32) mit Innenelektroden (76) des Piezostapels (12), und eine elektrisch leitfähige Kontaktierungseinrichtung (36) zum elektrischen Kontaktieren des Kontaktierungsbauelements (32) von außerhalb des Piezostapels (12),
wobei die Mäanderstruktur (34) und die Kontaktierungseinrichtung (36) beabstandet zueinander angeordnet sind, wobei ein Verbindungselement (38) zum elektrisch leitfähigen Verbinden der Kontaktierungseinrichtung (36) und der Mäanderstruktur (34) und zum Kräfteentkoppeln zwischen der Kontaktierungseinrichtung (36) und der Mäanderstruktur (34) vorgesehen ist,
**dadurch gekennzeichnet, dass** das Verbindungselement (38) eine Vielzahl von Drahtelementen (46) aufweist, die auf einer ersten Drahtelementseite (50) mit der Mäanderstruktur (34) und auf einer zweiten Drahtelementseite (48), die der ersten Drahtelementseite (48) gegenüberliegt, mit der Kontaktierungseinrichtung (36) verbunden sind, wobei sich die Drahtelemente (46) im Wesentlichen parallel zueinander erstrecken, wobei die Drahtelemente (46) im Wesentlichen senkrecht zu der Längserstreckungsrichtung (42) der Mäanderstruktur (34) angeordnet sind.

2. Kontaktierungsbauelement (32) nach Anspruch 1,
**dadurch gekennzeichnet, dass** sich die Mäanderstruktur (34) in einer Längserstreckungsrichtung (42) erstreckt, wobei die Kontaktierungseinrichtung (36) im Wesentlichen parallel zu der Längserstreckungsrichtung (42) angeordnet ist.

3. Kontaktierungsbauelement (32) nach einem der Ansprüche 1 oder 2,
**dadurch gekennzeichnet, dass** die Drahtelemente (46) zum Entkoppeln von axialen und/oder radialen und/oder lateralen und/oder Torsionskräften (24, 26, 28, 30) zwischen der Kontaktierungseinrichtung (36) und der Mäanderstruktur (34) ausgebildet sind, wobei die Drahtelemente (46) insbesondere so zwischen Mäanderstruktur (34) und Kontaktierungseinrichtung (36) angeordnet sind, dass sie wenigstens in einer Raumrichtung, vorzugsweise in zwei Raumrichtungen, insbesondere in drei Raumrichtungen, flexibel sind, wobei die Drahtelemente (46) insbesondere biegeweich sind.

4. Kontaktierungsbauelement (32) nach einem der Ansprüche 1 bis 3,
**dadurch gekennzeichnet, dass** die Mäanderstruktur (34) in der Längserstreckungsrichtung (42) einen ersten Endbereich (54) und einen zweiten Endbereich (56) aufweist, wobei die Kontaktierungseinrichtung (36) wenigstens über einen der Endbereiche (54, 56) der Mäanderstruktur (34) hervorsteht, wobei die Kontaktierungseinrichtung (36) insbesondere als Flachkontaktelement (58) ausgebildet ist.

5. Kontaktierungsbauelement (32) nach einem der Ansprüche 1 bis 4,
**dadurch gekennzeichnet, dass** die Mäanderstruktur (34) und die Kontaktierungseinrichtung (36) und das Verbindungselement (38) einstückig ausgebildet sind, wobei die Mäanderstruktur (34), das Verbindungselement (38) und die Kontaktierungseinrichtung (36) vorzugsweise in einer Dickenrichtung (59), die senkrecht zu der Längserstreckungsrichtung (42) der Mäanderstruktur (34) und senkrecht zu einer Drahterstreckungsrichtung (51) zwischen der Kontaktierungseinrichtung (36) und der Mäanderstruktur (34) angeordnet ist, eine gleiche Dicke (59') aufweisen.

6. Kontaktierungsbauelement (32) nach einem der Ansprüche 4 oder 5, **dadurch gekennzeichnet, dass** an der Kontaktierungseinrichtung (36) in einem Abstandsbereich (64), der parallel zu dem Endbereich (56) der Mäanderstruktur (34) angeordnet ist, über den die Kontaktierungseinrichtung (36) hervorsteht, ein Abzweigungselement (66) angeordnet ist, das sich parallel zu der Längserstreckungsrichtung (42) erstreckt und unter Ausbildung eines Abstandes (70) beabstandet zu der Kontaktierungseinrichtung (36) verläuft, wobei die Drahtelemente (46) in dem Abstandsbereich (64) an dem Abzweigungselement (66) statt an der Kontaktierungseinrichtung (36) befestigt sind.

7. Piezobauelement (10), aufweisend
einen Piezostapel (12) mit einer Mehrzahl von in einer Längserstreckungsrichtung (42) des Piezostapels (12) übereinandergestapelten piezoelektrischen Elementen (72) mit dazwischen angeordneten Elektrodenschichten (74) zur Bildung von Innenelektroden (76), und
wenigstens ein Kontaktierungsbauelement (32) nach einem der Ansprüche 1 bis 6 zum elektrischen Kontaktieren des Piezostapels (12).

8. Piezobauelement (10) nach Anspruch 7,
**dadurch gekennzeichnet, dass** die Mäanderstruktur (34) in direktem Kontakt mit dem Piezostapel (12) angeordnet ist, und dass die Kontaktierungseinrichtung (36) und das Verbindungselement (38) radial zu dem Piezostapel (12) beabstandet angeordnet sind.

9. Piezobauelement (10) nach einem der Ansprüche 7 oder 8, **dadurch gekennzeichnet, dass** die Mäanderstruktur (34), insbesondere unter Verwendung von Leitkleber (78), an eine Seitenfläche (14, 14') des Piezostapels (12) geklebt ist, oder dass die Mäanderstruktur (34) an eine Außenmetallisierung (16) des Piezostapels (12) gelötet ist.

10. Piezobauelement (10) nach einem der Ansprüche 7 bis 9, **dadurch gekennzeichnet, dass** der Piezostapel (12) wenigstens vier Seitenflächen (14) aufweist, die über Eckbereiche (79) miteinander verbunden sind,
wobei die Mäanderstruktur (34) an einer ersten Seitenfläche (14) angeordnet ist,
wobei die Kontaktierungseinrichtung (36) an einer zweiten Seitenfläche (14'), die zu der ersten Seitenfläche (14) benachbart ist, angeordnet ist,
wobei sich das Verbindungselement (38) um einen die erste und die zweite Seitenfläche (14, 14') verbindenden Eckbereich (79) herum erstreckt.

11. Piezobauelement (10) nach einem der Ansprüche 7 bis 10, **dadurch gekennzeichnet, dass** der Piezostapel (12) einen ersten und einen zweiten Abschlussbereich (84, 86) aufweist, wobei sich die Kontaktierungseinrichtung (36) über wenigstens einen der Abschlussbereiche (84) hinaus erstreckt.

12. Piezobauelement (10) nach einem der Ansprüche 7 bis 11, **dadurch gekennzeichnet, dass** zwei Kontaktierungsbauelemente (32) vorgesehen sind, deren Mäanderstrukturen (34) jeweils an sich gegenüberliegenden Seitenflächen (14, 14') des Piezostapels (12) angeordnet sind.

13. Verfahren zum Herstellen eines Piezobauelements (10), aufweisend die Schritte:
a) Bereitstellen eines Piezostapels (12) mit einer Mehrzahl von in einer Längserstreckungsrichtung (42) des Piezostapels (12) übereinandergestapelten piezoelektrischen Elementen (72) mit dazwischen angeordneten Elektrodenschichten (74) als Innenelektroden (76), wobei der Piezostapel (12) wenigstens vier Seitenflächen (14, 14', 14", 14''') aufweist, die über Eckbereiche (79) miteinander verbunden sind;
b) Bilden eines Kontaktierungsbauelements (32) nach einem der Ansprüche 1 bis 6;
c) elektrisch leitfähiges Befestigen der Mäanderstruktur (34) an einer ersten Seitenfläche (14) des Piezostapels (12) derart, dass die Kontaktierungseinrichtung (36) und das Verbindungselement (38) beabstandet zu dem Piezostapel (12) verbleiben;
d) Umbiegen der Kontaktierungseinrichtung (36) und des Verbindungselements (38) auf eine zweite Seitenfläche (14') des Piezostapels (12), die zu der ersten Seitenfläche (14) benachbart ist, um einen die erste und die zweite Seitenfläche (14, 14') verbindenden Eckbereich (79), wobei die Kontaktierungseinrichtung (36) und das Verbindungselement (38) beabstandet zu der zweiten Seitenfläche (14') und dem Eckbereich (79) verbleiben.

## Claims

1. Contacting component (32) for the electrical contacting of a piezo stack (12),
having an electrically conductive meandering structure (34) for establishing electrical contact between the contacting component (32) and inner electrodes (76) of the piezo stack (12), and an electrically conductive contacting device (36) for the electrical contacting of the contacting component (32) from outside the piezo stack (12),
wherein the meandering structure (34) and the contacting device (36) are arranged spaced apart from one another, wherein a connecting element (38) is provided for the electrically conductive connection of the contacting device (36) and of the meandering structure (34) and for the decoupling, in terms of forces, between the contacting device (36) and the meandering structure (34), **characterized in that** the connecting element (38) has a multiplicity of wire elements (46) which are connected, on a first wire element side (50), to the meandering structure (34) and which are connected, on a second wire element side (48) situated opposite the first wire element side (50), to the contacting device (36), wherein the wire elements (46) extend substantially parallel to one another, wherein the wire elements (46) are arranged substantially perpendicular to the direction of longitudinal extent (42) of the meandering structure (34).

2. Contacting component (32) according to Claim 1,
**characterized in that** the meandering structure (34) extends in a direction of longitudinal extent (42), wherein the contacting device (36) is arranged substantially parallel to the direction of longitudinal extent (42).

3. Contacting component (32) according to either of Claims 1 and 2,
**characterized in that** the wire elements (46) are designed for the decoupling of axial and/or radial and/or lateral and/or torsional forces (24, 26, 28, 30) between the contacting device (36) and the meandering structure (34), wherein the wire elements (46) are in particular arranged between the meandering structure (34) and contacting device (36) so as to be flexible at least in one spatial direction, preferably in two spatial directions, in particular in three spatial directions, wherein the wire elements (46) are in particular flexurally soft.

4. Contacting component (32) according to one of Claims 1 to 3,
**characterized in that** the meandering structure (34) has, in the direction of longitudinal extent (42), a first end region (54) and a second end region (56), wherein the contacting device (36) protrudes at least beyond one of the end regions (54, 56) of the meandering structure (34), wherein the contacting device (36) is in particular in the form of a flat contact element (58).

5. Contacting component (32) according to one of Claims 1 to 4,
**characterized in that** the meandering structure (34) and the contacting device (36) and the connecting element (38) are formed in one piece, wherein the meandering structure (34), the connecting element (38) and the contacting device (36) preferably have a uniform thickness (59') in a thickness direction (59) which is arranged perpendicular to the direction of longitudinal extent (42) of the meandering structure (34) and perpendicular to a direction of wire extent (51) between the contacting device (36) and the meandering structure (34).

6. Contacting component (32) according to either of Claims 4 and 5,
**characterized in that**, on the contacting device (36), in a spacing region (64) which is arranged parallel to that end region (56) of the meandering structure (34) beyond which the contacting device (36) protrudes, there is arranged a branch element (66) which extends parallel to the direction of longitudinal extent (42) and which runs spaced apart from the contacting device (36) with the formation of a spacing (70), wherein the wire elements (46) are, in the spacing region (64), fastened to the branch element (66) rather than to the contacting device (36) .

7. Piezo component (10), having
a piezo stack (12) with a multiplicity of piezoelectric elements (72) which are stacked one above the other in a direction of longitudinal extent (42) of the piezo stack (12) and which have interposed electrode layers (74) for forming inner electrodes (76), and
at least one contacting component (32) according to one of Claims 1 to 6 for the electrical contacting of the piezo stack (12).

8. Piezo component (10) according to Claim 7,
**characterized in that** the meandering structure (34) is arranged in direct contact with the piezo stack (12), and **in that** the contacting device (36) and the connecting element (38) are arranged so as to be spaced apart radially from the piezo stack (12).

9. Piezo component (10) according to either of Claims 7 and 8, **characterized in that** the meandering structure (34) is adhesively bonded, in particular using conductive adhesive (78), to a side face (14, 14') of the piezo stack (12), or **in that** the meandering structure (34) is soldered to an external metallic coating (16) of the piezo stack (12).

10. Piezo component (10) according to one of Claims 7 to 9, **characterized in that** the piezo stack (12) has at least four side faces (14) which are connected to one another via corner regions (79),
wherein the meandering structure (34) is arranged on a first side face (14),
wherein the contacting device (36) is arranged on a second side face (14') which is adjacent to the first side face (14),
wherein the connecting element (38) extends around a corner region (79) which connects the first and the second side faces (14, 14').

11. Piezo component (10) according to one of Claims 7 to 10, **characterized in that** the piezo stack (12) has a first and a second termination region (84, 86), wherein the contacting device (36) extends beyond at least one of the termination regions (84).

12. Piezo component (10) according to one of Claims 7 to 11, **characterized in that** two contacting components (32) are provided, the meandering structures (34) of which are arranged in each case on mutually opposite side faces (14, 14') of the piezo stack (12).

13. Method for producing a piezo component (10), having the steps:
a) providing a piezo stack (12) having a multiplicity of piezoelectric elements (72) which are stacked one above the other in a direction of longitudinal extent (42) of the piezo stack (12) and which have interposed electrode layers (74) as inner electrodes (76), wherein the piezo stack (12) has at least four side faces (14, 14', 14", 14''') which are connected to one another via corner regions (79);
b) forming a contacting component (32) according to one of Claims 1 to 6;
c) fastening the meandering structure (34) in electrically conductive fashion to a first side face (14) of the piezo stack (12) such that the contacting device (36) and the connecting element (38) remain spaced apart from the piezo stack (12);
d) bending the contacting device (36) and the connecting element (38) against a second side face (14'), which is adjacent to the first side face (14), of the piezo stack (12) about a corner region (79) which connects the first and the second side faces (14, 14'), wherein the contacting device (36) and the connecting element (38) remain spaced apart from the second side face (14') and from the corner region (79).

## Revendications

1. Composant de contact (32) destiné à mettre en contact électrique un empilement piézoélectrique (12),
comportant une structure en méandres électriquement conductrice (34) destinée à mettre en contact électrique le composant de contact (32) avec des électrodes internes (76) de l'empilement piézoélectrique (12), et un dispositif de contact électriquement conducteur (36) destiné à établir un contact électrique avec le composant de contact (32) depuis l'extérieur de l'empilement piézoélectrique (12),
dans lequel la structure en méandres (34) et le dispositif de contact (36) sont disposés de manière espacée l'un de l'autre, dans lequel il est prévu un élément de liaison (38) destiné à relier de manière électriquement conductrice le dispositif de contact (36) et la structure en méandres (34) et à découpler les forces entre le dispositif de contact (36) et la structure en méandres (34),
**caractérisé en ce que** l'élément de liaison (38) comporte une pluralité d'éléments de fils (46) qui sont reliés à la structure en méandres (34) sur un premier côté d'élément de fil (50) et au dispositif de contact (36) sur un second côté d'élément de fil (48) opposé au premier côté d'élément de fil (48), dans lequel les éléments de fil (46) s'étendent sensiblement parallèlement les uns aux autres, dans lequel les éléments de fil (46) sont disposés sensiblement perpendiculairement à la direction d'extension longitudinale (42) de la structure en méandres (34).

2. Composant de contact (32) selon la revendication 1, **caractérisé en ce que** la structure en méandres (34) s'étend dans une direction d'extension longitudinale (42), dans lequel le dispositif de contact (36) est disposé sensiblement parallèlement à la direction d'extension longitudinale (42).

3. Composant de contact (32) selon l'une des revendications 1 ou 2,
**caractérisé en ce que** les éléments de fil (46) sont conçus pour découpler des forces axiales et/ou radiales et/ou latérales et/ou de torsion (24, 26, 28, 30) entre le dispositif de contact (36) et la structure en méandres (34), dans lequel les éléments de fil (46) sont en particulier disposés entre la structure en méandres (34) et le dispositif de contact (36) de manière à ce qu'ils soient flexibles au moins dans une direction spatiale, de préférence dans deux directions spatiales, en particulier dans trois directions spatiales, dans lequel les éléments de fil (46) peuvent en particulier être recourbés.

4. Composant de contact (32) selon l'une des revendications 1 à 3, **caractérisé en ce que** la structure en méandres (34) comporte une première région d'extrémité (54) et une seconde région d'extrémité (56) dans la direction d'extension longitudinale (42), dans lequel le dispositif de contact (36) dépasse d'au moins l'une des régions d'extrémité (54, 56) de la structure en méandres (34), dans lequel le dispositif de contact (36) est en particulier réalisé sous la forme d'un élément de contact plat (58).

5. Composant de contact (32) selon l'une des revendications 1 à 4,
**caractérisé en ce que** la structure en méandres (34), le dispositif de contact (36) et l'élément de liaison (38) sont réalisés en une seule pièce, dans lequel la structure en méandres (34), l'élément de liaison (38) et le dispositif de contact (36), de préférence dans une direction d'épaisseur (59), qui sont disposés perpendiculairement à la direction d'extension longitudinale (42) de la structure en méandres (34) et perpendiculairement à une direction d'extension de fil (51) entre le dispositif de contact (36) et la structure en méandres (34), présentent la même épaisseur (59').

6. Composant de contact (32) selon l'une des revendications 4 ou 5,
**caractérisé en ce qu'**un élément de dérivation (66) est disposé au niveau du dispositif de contact (36) dans une région d'espacement (64) qui est disposée parallèlement à la région d'extrémité (56) de la structure en méandres (34) au-dessus de laquelle le dispositif de contact (36) fait saillie, qui s'étend parallèlement à la direction d'extension longitudinale (42) et est espacé en formant un espacement (70) par rapport au dispositif de contact (36), dans lequel les éléments de fil (46) sont fixés à l'élément de dérivation (66) dans la région d'espacement (64) au lieu du dispositif de contact (36).

7. Composant piézoélectrique (10) comportant
un empilement piézoélectrique (12) comportant une pluralité d'éléments piézoélectriques (72) empilés les uns sur les autres dans une direction d'extension longitudinale (42) de l'élément piézoélectrique (12) et comportant des couches d'électrodes (74) disposées entre ceux-ci pour former des électrodes internes (76), et
au moins un élément de contact (32) selon l'une des revendications 1 à 6 destiné à la mise en contact électrique avec l'élément piézoélectrique (12).

8. Composant piézoélectrique (10) selon la revendication 7, **caractérisé en ce que** la structure en méandres (34) est disposée en contact direct avec l'empilement piézoélectrique (12), et **en ce que** le dispositif de contact (36) et l'élément de liaison (38) sont disposés de manière à ce que l'espacement axial entre le dispositif de contact (36) et l'élément de liaison (38) soient disposés en étant radialement espacés par rapport à l'empilement piézoélectrique (12).

9. Composant piézoélectrique (10) selon l'une des revendications 7 ou 8,
**caractérisé en ce que** la structure en méandres (34) est collée, notamment au moyen d'un adhésif conducteur (78), à une surface latérale (14, 14') de l'empilement piézoélectrique (12), ou **en ce que** la structure en méandres (34) est soudée à une métallisation extérieure (16) de l'empilement piézoélectrique (12) .

10. Composant piézoélectrique (10) selon l'une des revendications 7 à 9,
**caractérisé en ce que** l'empilement piézoélectrique (12) comporte au moins quatre surfaces latérales (14) qui sont reliées entre elles par des régions d'angle (79),
dans lequel la structure en méandres (34) est disposée sur une première surface latérale (14),
dans lequel le dispositif de contact (36) est disposé sur une seconde surface latérale (14') adjacente à la première surface latérale (14),
dans lequel l'élément de liaison (38) s'étend autour d'une région d'angle (79) reliant les première et seconde surfaces latérales (14, 14').

11. Composant piézoélectrique (10) selon l'une des revendications 7 à 10,
**caractérisé en ce que** l'empilement piézoélectrique (12) comporte des première et seconde régions d'extrémité (82, 86), dans lequel le dispositif de contact (36) s'étend au-delà d'au moins l'une des régions d'extrémité (82).

12. Composant piézoélectrique (10) selon l'une des revendications 7 à 11,
**caractérisé en ce qu'**il est prévu deux dispositifs de contact (32), dont les structures en méandres (34) sont respectivement disposées sur des surfaces latérales opposées (14, 14') de l'empilement piézoélectrique (12).

13. Procédé de fabrication d'un dispositif piézoélectrique (10) comprenant les étapes consistant à :
a) fournir un empilement piézoélectrique (12) comportant une pluralité d'éléments piézoélectriques (72) empilés les uns sur les autres dans une direction d'extension longitudinale (42) de l'empilement piézoélectrique (12), comportant des couches d'électrodes (74) disposées entre ceux-ci en tant qu'électrodes internes (76), dans lequel l'empilement piézoélectrique (12) comporte au moins quatre surfaces latérales (14, 14', 14", 14''') qui sont reliées entre elles par des régions d'angle (79) ;
b) former un élément de contact (32) selon l'une des revendications 1 à 6,
c) fixer de manière électriquement conductrice la structure en méandres (34) à une première surface latérale (14) de l'empilement piézoélectrique (12) de manière à ce que le dispositif de contact (36) et l'élément de liaison (38) restent espacés de l'empilement piézoélectrique (12) ;
d) recourber le dispositif de contact (36) et l'élément de liaison (38) sur une seconde surface latérale (14') de l'empilement piézoélectrique (12), qui est adjacente à la première surface latérale (14), autour d'une région d'angle (79) reliant les première et seconde surfaces latérales (14, 14'), dans lequel le dispositif de contact (36) et l'élément de liaison (38) restent espacés de la seconde surface latérale (14') et de la région d'angle (79).
